(19) Europäisches Patentamt
European Patent Office
Office européen des brevets

(11) Publication number: **0 252 150 B1**

(12) **EUROPEAN PATENT SPECIFICATION**

(45) Date of publication of patent specification: **30.12.92**

(51) Int. Cl.5: **G03F 7/12**, C08F 8/30, C08F 299/00, C08L 29/04

(21) Application number: **86900627.0**

(22) Date of filing: **06.01.86**

(86) International application number: **PCT/JP86/00001**

(87) International publication number: **WO 87/04271 (16.07.87 87/15)**

# (54) PHOTOSENSITIVE RESIN COMPOSITION FOR SCREEN PROCESS.

(43) Date of publication of application: **13.01.88 Bulletin 88/02**

(45) Publication of the grant of the patent: **30.12.92 Bulletin 92/53**

(84) Designated Contracting States: **DE GB**

(56) References cited:
**JP-A- 4 838 716**
**JP-A- 5 085 329**
**JP-A-58 194 905**
**JP-A- 5 083 101**
**JP-A- 5 562 446**
**US-A- 4 154 614**

**PATENT ABSTRACTS OF JAPAN vol. 7, no. 23 (P-171)(1168) 29 January 1983**

**PATENT ABSTRACTS OF JAPAN vol. 4, no. 103 (P-20)(585) 23 July 1980**

(73) Proprietor: **Japan as represented by Director-General, Agency of Industrial Science and Technology**
**3-1, Kasumigaseki 1-chome Chiyoda-ku**
**Tokyo 100(JP)**

Proprietor: **DAICEL CHEMICAL INDUSTRIES, LTD.**
**No. 1-Banchi, Teppo-cho**
**Sakai-shi Osaka-fu 590(JP)**

(72) Inventor: **ICHIMURA, Kunihiro**
**630-2, Matsushiro 5-chome**
**Yatabemachi, Tsukuba-gun Ibaraki-ken 305(JP)**
Inventor: **KUBO, Keiji**
**538-137, Taishimachi Hara**
**Ibo-gun Hyogo-ken 671-15(JP)**
Inventor: **SHIMIZU, Shigenobu**
**3-1, Nishimiyahara 3-chome Yodogawa-ku**
**Osaka-shi Osaka 532(JP)**

(74) Representative: **Patentanwälte Grünecker, Kinkeldey, Stockmair & Partner**
**Maximilianstrasse 58**
**W-8000 München 22(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a photosensitive resin composition for screen processing.

Screen printing has various advantages such as, for example, easy printing operation, high image accuracy, freeness from strict limitation with respect to print base and large building-up of an applied ink. Thus, it is employed in diverse fields, while it is expanding its scope of application fields with a rapidly increasing demand therefor.

The so-called direct process for producing a screen plate comprises applying a photosensitive emulsion prepared by mixing a photosensitive agent such as a dichromate or a diazo resin with polyvinyl alcohol and a polyvinyl acetate emulsion to a screen made of a polyester or a nylon and stuck on a frame to form a photosensitive coating film. In the direct process, however, the application step disadvantageously takes a long time, and provides a large variation of the thickness of the coating film and a lack of evenness of the coating film surface entailing a reduced resolution, because of repetition of manual application work and drying.

As a result of investigations with a view to obviating the disadvantages of the above-mentioned conventional process comprising directly applying a photosensitive emulsion onto a surface of a screen to form a coating film, the inventor of the present invention found that a procedure comprising preparation of a photosensitive material for screen processing by coating a plastic film with a photosensitive emulsion, sticking of the photosensitive material to the surface of a screen with the aid of water or a photosensitive emulsion, and removal of the plastic film after drying can curtail the working steps and provide a uniform thickness of the coating film on the surface of a screen to materialize a screen printing plate with a very high accuracy. Based on this finding, the inventor disclosed an invention in Japanese Patent Laid-Open No. 85,048/1982.

In this procedure, however, a dichromate used as the photosensitive agent, though highly sensitive, limits the working steps because of a rapid dark reaction thereof after coating, and presents a problem of pollution with hexavalent chromium which, therefore, limits the usage of the dichromate. On the other hand, a diazo resin is low in sensitivity and slow in dark reaction, but the dark reaction still unsatisfactorily proceeds.

Thereafter, Japanese Patent Publication No. 40,814/1981 and Japanese Patent Laid-Open No. 194,905/1983 disclosed highly sensitive photosensitive resin compositions having no liability to undergo a dark reaction and containing no metal supposed to be a source of environmental pollution which comprise a photo-crosslinking polyvinyl alcohol containing stilbazolium or chalcone groups, respectively, and a film-forming polymeric compound. However, they involve the following problems.

1) Insufficient adhesion of a cured film formed by exposure to light which sometimes causes peeling of the cured film from a screen during spray development.

2) No latent image appears even when a coating film is exposed to light after formation of the coating film according to an ordinary procedure of direct coating of a screen with a photosensitive resin composition and drying, or another ordinary procedure of coating of a plastic film with a photosensitive resin composition, sticking of the composition to the surface of a screen with the aid of water, and removal of the plastic film after drying. This makes it impossible to judge whether or not light exposure has already been performed.

3) Portions where spraying is to be effected are sometimes overlooked because of non-appearance of a latent image.

JP-A-55-62446 relates to a photosensitive resin composition for a screen printing plate comprising 0.05 to 2 wt. pts. of saponified polyvinylacetate having a saponification value of at least 75 mol % and which contains photo-crosslinkable units of the general formula below as well as a film forming polymer compound:

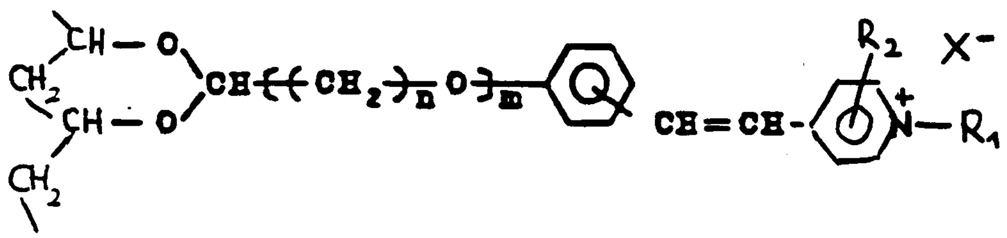

wherein $R_1$ is $H_1$ alkyl or aralkyl substituted by an -OH group, carbamoyl, ether and unsaturated groups; $R_2$

is H or lower alkyl, $X^-$ is an ion of halogen, phosphonic acid, sulfuric acid, metasulfuric acid, p-toluenesulfonic acid; m is 0 or 1 and n is an integer of 1 to 6.

It is the object of the present invention to provide a photosensitive resin composition for screen processing having a high photosensitivity and an excellent adhesion of a cured film formed therefrom to a screen and which is capable of confirmation of a latent image in exposure to light.

The photosensitive resin composition for screen processing of the present invention, which has attained the above-mentioned object , comprises a film-forming polymeric compound and a photo-crosslinkable polyvinyl alcohol containing photo-crosslinkable units of at least one member selected from the group consisting of units represented by the general formulae (I), (II) or (III):

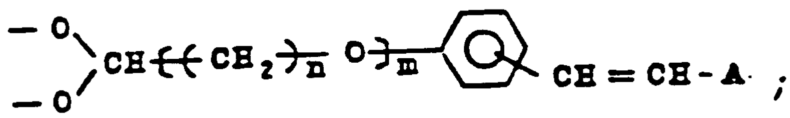

(I)

wherein A is selected from groups represented by the general formulae (1) or (2):

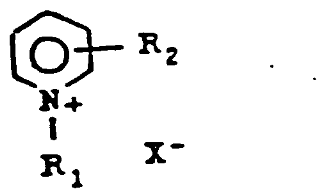

(1)

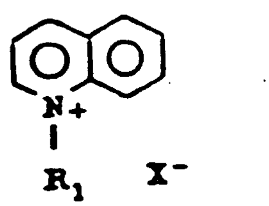

(2)

wherein $R_1$ is a hydrogen atom, or an alkyl or aralkyl group which may contain a hydroxyl group, a carbamoyl group, an ether group, or an unsaturated group; $R_2$ is a hydrogen atom or a lower alkyl group; and $X^-$ is an anion,

m is an integer of 0 or 1, and n is an integer of 1 to 6;

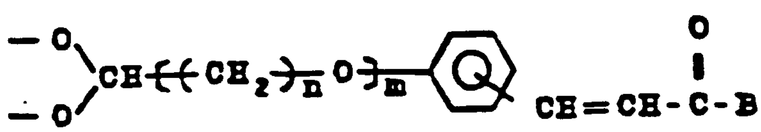

(II)

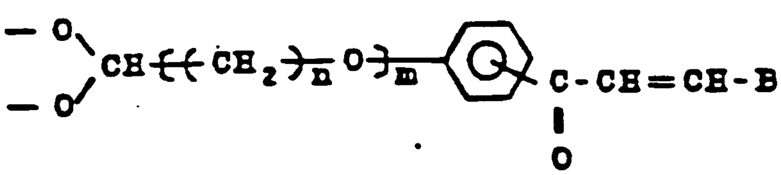

(III)

wherein B is an aromatic or heterocyclic group having at least one kind of polar group; and m and n are as defined in the general formula (I);

wherein said photo-crosslinkable polyvinyl alcohol is prepared from polyvinyl alcohol having a degree of saponification of 75 mol % or more **characterized in that** said polyvinyl alcohol contains 0,5 to 10 mol % of photo-crosslinkable units, the polyvinyl alcohol used to prepare the photo-crosslinkable polyvinyl alcohol has a degree of polymerization of 300 to 3,000, the ratio of the film-forming polymeric compound to the

photo-crosslinkable polyvinyl alcohol in the photosensitive resin composition for screen processing is 100 parts by weight: 10 to 200 parts by weight, and the composition further comprises a diazo compound.

The film-forming polymeric compound may be used in the form of an emulsion containing the same. Usable emulsions include those of vinyl acetate, acrylic, ethylene-vinyl acetate, ethylene-acrylic, vinyl chloride and vinylidene chloride, and an SBR (styrene butadiene rubber) latex.

The photo-crosslinkable polyvinyl alcohol to be used in the present invention is obtained by introducing the above-mentioned photo-crosslinkable units represented by the general formulae (I), (II), or (III) into a polyvinyl alcohol prepared by completely or partially saponifying a polyvinyl acetate. Introduction of the photo-crosslinkable units represented by the general formula (I), (II), or (III) can be effected by a known method such as one disclosed in Japanese Patent Publication No. 5,761/1981 or 5,762/1981, or Japanese Patent Laid-Open No. 194,905/1983. The method of synthesis of the polyvinyl alcohol containing photo-crosslinkable units of the general formula (I) will be described as the representative example. Specifically, polyvinyl alcohol is reacted in the presence of an acid catalyst with a stilbazolium or styrylquinolinium salt compound respectively represented by a general formulae (IV) or (V):

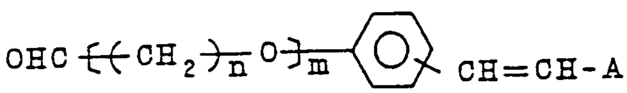

(IV)

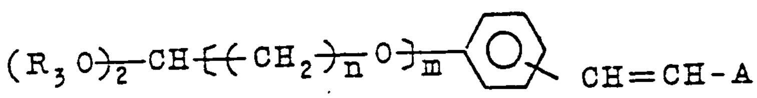

(V)

(wherein A, m, and n are as defined above; and $R_3$ is a lower alkyl group, or two $R_3$ groups constitute an alkylene group),
whereby a photo-crosslinkable polyvinyl alcohol having the stilbazolium or styrylquinolinium groups introduced thereinto is obtained.

Examples of the compound represented by the general formula (IV) include 1-methyl-2-(p-formylstyryl)-pyridinium, 1-methyl-4-(p-formylstyryl)pyridinium, 1-ethyl-2-(p-formylstyryl)pyridinium, 1-ethyl-4-(p-formylstyryl)pyridinium, 1-allyl-4-(p-formylstyryl)pyridinium, 1-(2-hydroxyethyl)-2-(p-formylstyryl)pyridinium, 1-(2-hydroxyethyl)-4-(p-formylstyryl)pyridinium, 1-carbamoylmethyl-2-(p-formylstyryl)pyridinium, 1-carbamoylmethyl-4-(p-formylstyryl)pyridinium, 1-methyl-2-(m-formylstyryl)pyridinium, 1-benzyl-2-(p-formylstyryl)pyridinium, 1-benzyl-4-(p-formylstyryl)pyridinium, 1-methyl-4-(p-formylstyryl)-5-ethylpyridinium, 1-methyl-2-(p-formylstyryl)-quinolinium, 1-ethyl-2-(p-formylstyryl)quinolinium, and 1-ethyl-4-(p-formylstyryl)-quinolinium.

The acetal compound of the formyl compound represented by the general formula (IV) may be used as the compound represented by the general formula (V). Usable anions represented by $X^-$ include halogen, phosphate, sulfate, methosulfate, and p-toluenesulfonate ions.

Examples of the aromatic or heterocyclic group B having a polar group in the photo-crosslinkable unit represented by the general formulae (II) or (III) include those substituted with a carboxylic acid or its salt, a sulfonic acid or its salt, or a primary, secondary, tertiary amine or its salt including a quaternary salt of a tertiary amine.

If the content of the photo-crosslinkable unit in the alcohol exceeds 0.5 to 10 mol % of the viscosity of the reaction product increases and makes the preparation thereof difficult. Furthermore, the water solubility of the obtained photosensitive resin composition becomes insufficient.

Diazo compounds usable in the present invention include tetrazolium salts, diazide compounds, diazonium salts, diazo resins which are condensates of a diazonium salt with formalin, and mixtures thereof with one or more kinds of known compounds. Particularly preferred is a diazo resin which is a condensate of 4-diazodiphenylamine with paraformaldehyde.

When the amount of the photo-crosslinkable polyvinyl alcohol is less than 10 parts by weight, the solvent resistance of the coating film is poor, leading to defects of poor printing resistance and poor wash out in an unexposed portion entailing insufficient development. When the amount exceeds 200 parts by weight, the water resistance and the surface smoothness becomes poor, and the sensitivity decreases.

The ratio of the diazo compound to the total of the film-forming polymeric compound and the photo-crosslinkable polyvinyl alcohol is preferably in the range of 100 parts by weight ; 0.01 to 2 parts by weight. When it is less than 0.01 part by weight, the adhesion of the cured film to the screen is so poor that the film

may be peeled or no latent image may be recognized. When it exceeds 2 parts by weight, the effect does not vary, and the sensitivity adversely decreases.

The photosensitive resin composition for screen processing of the present invention exhibits a high sensitivity even with a small amount of the photo-crosslinkable units, and is not affected by oxygen in air. Furthermore, the photosensitive resin composition can be stored for a long period of time since it does not give rise to any dark reaction even in a state of a solution or a dried coating film.

A small amount of an adequate dye may be incorporated into the above-mentioned photosensitive resin composition composed of the film-forming polymeric compound, the photo-crosslinkable polyvinyl alcohol, and the diazo compound, for example, in order to facilitate inspection of pinholes in an image formed by light exposure and development. In order to improve the various performance characteristics of the film, small amounts of a plasticizer, a surface-active agent, a lubricant, a fine powder, and various additives may be added.

The photosensitive resin composition for screen processing of the present invention including the above-mentioned various additives may be applied to a screen, dried, exposed to light, and developed according to a customary method to produce a screen printing plate. Alternatively, as disclosed in Japanese Patent Laid-Open No. 85,048/1982 by the inventor of the present invention, the photosensitive resin composition may be applied to a plastic film to form a photosensitive film for screen processing, which is then stuck to the surface of a screen with the aid of, for example, water, dried, stripped of the plastic film, exposed to light, and developed to produce a screen printing plate.

The following Referential Examples and Examples will illustrate the present invention in more detail.

Referential Example 1

110 g of N-methyl-γ-picolinium methosulfate and 200 g of terephthalaldehyde were dissolved in 400 ml of methanol under heating, and admixed with 6 ml of piperizine, followed by reflux for 3 h. After cooling, ethanol was distilled off under reduced pressure, and washing was effected with ethyl acetate. The precipitate obtained was dissolved in hot ethanol, and slowly admixed with ethyl acetate to precipitate crystals, which were then washed with ethyl acetate and dried to obtain 120 g of N-methyl-γ-(p-formylstyryl)pyridinium methosulfate.

Referential Example 2

50 g of p-hydroxybenzaldehyde and 15 g of sodium hydroxide were dissolved in 100 ml of ethyl cellosolve, and admixed with 74 g of bromoacetaldehyde dimethyl acetal, followed by reflux for 20 h. After cooling, benzene was added to the reaction mixture, followed by washing with water once and with dilute alkali till no hydroxylaldehyde remained. The resulting benzene solution was dried with anhydrous potassium carbonate, and distilled to obtain 36 g of p-formylphenoxyacetaldehyde dimethyl acetal.

21 g of the obtained p-formylphenoxyacetaldehyde dimethyl acetal and 22 g of N-methyl-γ-picolinium methosulfate were dissolved in 90 ml of methanol, and admixed with 4 ml of piperizine, followed by reflux for 4 h. Thereafter, the reaction mixture was cooled. The precipitated crystals were filtered, sufficiently washed with acetone, and dried to obtain 30 g of N-methyl-4-{p-(2,2-dimethoxyethoxy)styryl}pyridinium methosulfate.

Referential Example 3 (preparation of photo-crosslinkable polyvinyl alcohol (A))

9 g of N-methyl-γ-(p-formylstyryl)pyridinium methosulfate obtained in Referential Example 1 and 100 g of polyvinyl alcohol having a degree of saponification of 88 mol % and a degree of polymerization of 1,700 were dissolved in 900 ml of water under heating. 5 g of 85 % phosphoric acid was added to the resulting solution, and the resulting mixture was heated at 60 °C for 5 h with stirring, followed by stirring at ordinary temperature for one day. The reaction mixture was poured into a large amount of acetone to precipitate a resin, which was sufficiently washed with methanol twice, and dried to obtain 98 g of the washed resin. The stilbazolium group content of the total polymer units of polyvinyl alcohol was about 1.2 mol %.

Referential Example 4 (preparation of photo-crosslinkable polyvinyl alcohol (B))

30 g of N-methyl-γ-(p-formylstyryl)pyridinium methosulfate was reacted with 100 g of polyvinyl alcohol having a degree of saponification of 88 % and a degree of polymerization of 500 in the same manner as in Referential Example 3 to obtain 105 g of a resin. The stilbazolium group content of the resin was about 3.5

mol %.

Referential Example 5 (preparation of photo-crosslinkable polyvinyl alcohol (C))

13 g of N-methyl-4-{p-(2,2-dimethoxyethoxy)styryl}pyridinium methosulfate obtained in Referential Example 2 was reacted with 100 g of polyvinyl alcohol having a degree of saponification of 88 % and a degree of polymerization of 1,400 in the same manner as in Referential Example 3 to obtain 100 g of a resin having a stilbazolium group content of about 1.5 mol %.

Referential Example 6

28.6 g of 2-methylquinoline and 6.7 g of terephthalaldehyde were refluxed together with 24 g of acetic acid and 45 g of acetic anhydride for 8 h. After cooling, the precipitated crystals were dissolved in dichloromethane, washed with water and with a sodium hydroxide solution to remove acetic acid. Concentrated hydrochloric acid was added to the dichloromethane solution to immediately precipitate bulky yellowish orange crystals. The crystals were recovered by filtration and recrystallized from water, followed by suspension thereof in about 300 ml of ethanol. The suspension was neutralized with triethylamine and heated to effect dehydrochlorination. Subsequently, 3.9 g of an undissolved diolefin compound was filtered off. Water was added to the filtrate and the resulting mixture was allowed to stand to obtain 35 g of yellow crystals of 2-(p-formylstyryl)quinoline. 8.14 g of 2-(p-formylstyryl)quinoline thus obtained was dissolved in 30 ml of ethyl acetate. 9.0 g of dimethylsulfuric acid was added to the resulting solution, followed by reflux for 6 h. After cooling, the precipitated crystals were recovered by filtration, and recrystallized from water to obtain 11.8 g of crystals of 1-methyl-2-(p-formylstyryl)quinolinium methosulfate.

Referential Example 7 (preparation of photo-crosslinkable polyvinyl alcohol (D))

20 g of 1-methyl-2-(p-formylstyryl)quinolinium methosulfate obtained in Referential Example 6 and 200 g of saponified polyvinyl acetate having a degree of saponification of 88 % and a degree of polymerization of 1,700 were dissolved in 2,000 ml of distilled water. 4 g of 85 % phosphoric acid was added to the resulting solution, and a reaction was effected with stirring at a temperature of 45 °C for 20 h.

Thereafter, the reaction mixture was neutralized with 10 % aqueous ammonia. 218 g of a photo-crosslinkable polyvinyl alcohol (D) having a styrylquinolinium group content of 1.0 mol % was contained in the resulting aqueous solution.

Example 1

300 g of an aqueous solution having a solids content of the photo-crosslinkable polyvinyl alcohol (A) obtained in Referential Example 3 of 10 % was well admixed with 10 g of an aqueous solution having a solids content of a diazo resin of a condensate of 4-diazodiphenylamine with paraformaldehyde of 10 % and 140 g of a commercially available polyvinyl acetate emulsion solids content: 50 %). The resulting photosensitive emulsion was applied to a 49 µm (300-mesh) polyester screen and dried to obtain a uniform film of about 3 µm. The screen was closely contacted with a positive original, and exposed to light at a distance of 1 m from a 3kW ultra-high pressure mercury lamp for 30 min . A latent image was confirmed. Thereafter, the screen was developed with water washing by means of a spray, and dried to obtain a screen printing plate having an excellent edge sharpness and including fine lines reproduced up to a line width of 100 µm. Printing was performed with the screen plate to obtain a very sharp print having a good image reproducibility. After printing, the ink was washed off. The screen was easily reproduced with a commercially available film stripping solution.

Example 2

A photosensitive emulsion of Example 1 was applied to the surface of a biaxially stretched polyethylene terephthalate film having a thickness of 75 µm by means of a curtain coater, and dried with not air of 60 °C to form a photosensitive coating film having a thickness of 30 µm.

The obtained photosensitive film for screen processing was stuck to a 63 µm (250-mesh) polyester screen plate stretched in a wooden frame with the aid of water, and dried by draft, followed by peeling of the polyester film.

The resulting screen printing plate was closely contacted with a positive original, exposed to light at a

distance of 1 m from a 3 kW ultra-high pressure mercury lamp for 40 s, developed by washing with warm water shower, and dried to obtain a pinhole-free screen printing plate having an excellent edge sharpness and including fine lines reproduced up to a line width of 100 µm.

Comparative Example 1

A photosensitive emulsion composed of 100 g of a 10 wt. % aqueous solution of the photo-crosslinkable polyvinyl alcohol (A) obtained in Referential Example 3 and 80 g of a polyvinyl acetate emulsion (the same as in Example 1) was applied to a ~63 µm (300-mesh) polyester screen, and dried to form a uniform film of about 10 um. The resulting screen printing plate was closely contacted with a positive original, and exposed to light at a distance of 1 m from a 3kW ultra-high pressure mercury lamp for 40 s. No latent image was recognized. The image was unfavorably peeled from the screen during development with water by means of a spray or gave a gritty surface.

Comparative Example 2

A photosensitive emulsion composed of 200 g of a 10 wt % aqueous solution the photo-crosslinkable polyvinyl alcohol obtained in Referential Example 7 and 60 g of a polyvinyl acetate emulsion (the same as in Example 1) was prepared, and applied to a screen, exposed to light, and developed in the same manner as in Comparative Example 1. The same phenomena as in Comparative Example 1 were recognized. The obtained image was hardly peeled with a commercially available film stripping solution. Thus, reproduction of the screen was difficult.

Example 3 to 7

Photosensitive emulsions having their respective compositions as shown in Table 1 were prepared from the photo-crosslinkable polyvinyl alcohols (A), (B), (C) and (D) obtained in Referential Examples 3 to 5 and 7, a polyvinyl acetate emulsion, and a diazo resin as used in Example 1. Photosensitive films were prepared and screen printing plates were obtained in the same manner as in Example 2. In every case, a latent image was confirmed and the adhesion thereof to the screen was good.

Table 1

| Ex. | Composition of photosensitive emulsion | | | Evaluation | |
|---|---|---|---|---|---|
| | Polyvinyl acetate emulsion | Photo-crosslinkable polyvinyl alcohol | diazo resin | Confirmation of latent image | Adhesion |
| 3 | 140 g (50 wt.%) | 300 g ((A), 10 wt.%) | 5 g (10 wt.%) | o | o |
| 4 | 100 g (50 wt.%) | 500 g ((C), 10 wt.%) | 5 g (10 wt.%) | o | o |
| 5 | 100 g (50 wt.%) | 500 g ((C), 10 wt.%) | 1 g (10 wt.%) | △ | o |
| 6 | 60 g (50 wt.%) | 200 g ((B), 10 wt.%) | 20 g (10 wt.%) | o | o |
| 7 | 140 g (50 wt.%) | 300 g ((D), 10 wt.%) | 10 g (10.wt.%) | o | o |
| Note: The figures in parentheses represent the proportion in terms of solids content. | | | | | |

**Claims**

1. A photosensitive resin composition for screen processing comprising a film-forming polymeric compound and a photo-crosslinkable polyvinyl alcohol containing photo-crosslinkable units of at least one member selected from the group consisting of units represented by the general formulae (I), (II) or (III):

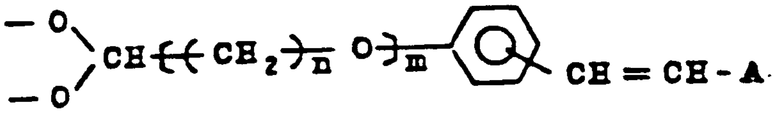 ; (I)

wherein A is selected from groups represented by the general formulae (1) or (2):

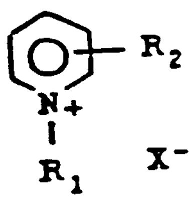 (1)

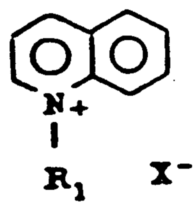 (2)

wherein $R_1$ is a hydrogen atom, or an alkyl or aralkyl group which may contain a hydroxyl group, a carbamoyl group, an ether group, or an unsaturated group; $R_2$ is a hydrogen atom or a lower alkyl group; and $X^-$ is an anion,

m is an integer of 0 or 1, and n is an integer of 1 to 6;

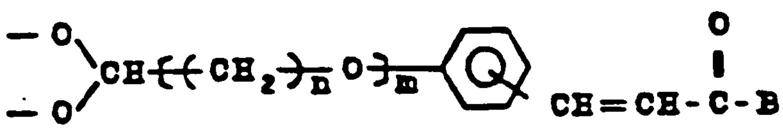 (II)

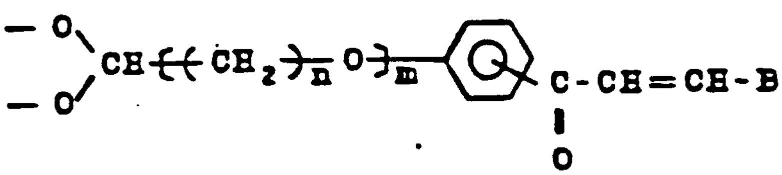 (III)

wherein B is an aromatic or heterocyclic group having at least one kind of polar group; and m and n are as defined in the general formula (I);

wherein said photo-crosslinkable polyvinyl alcohol is prepared from polyvinyl alcohol having a degree of saponification of 75 mol % or more **characterized in that** said polyvinyl alcohol contains 0,5 to 10 mol % of photo-crosslinkable units, the polyvinyl alcohol used to prepare the photo-crosslinkable polyvinyl alcohol has a degree of polymerization of 300 to 3,000, the ratio of the film-forming polymeric compound to the photo-crosslinkable polyvinyl alcohol in the photosensitive resin composition for screen processing is 100 parts by weight: 10 to 200 parts by weight, and the composition further comprises a diazo compound.

2. The photosensitive resin composition of claim 1, **characterized in that** B of the general formulae (II) and (III) is an aromatic or heterocyclic group substituted with a carboxylic acid or its salt, a sulfonic acid

or its salt, or a primary, secondary, tertiary amine or its salt including a quaternary salt of a tertiary amine.

3. The photosensitive resin composition of any of claims 1 or 2 **characterized in that** the diazo compound is selected from tetrazolium salts, diazide compounds, diazonium salts, diazo resins which are condensates of a diazonium salt with formalin, and mixtures thereof.

4. The photosensitive resin composition of claim 3, **characterized in that** the diazo compound is a condensate of 4-diazo-diphenylamine with paraformaldehyde.

**Patentansprüche**

1. Lichtempfindliche Harzzusammensetzung für ein Siebdruckverfahren, das eine Film-bildende Polymerverbindung und einen lichtvernetzbaren Polyvinylalkohol umfaßt, der lichtvernetzbare Struktureinheiten von mindestens einem Mitglied, ausgewählt aus der Gruppe, bestehend aus den durch die allgemeinen Formeln (I), (II) oder (III) dargestellten Struktureinheiten, enthält:

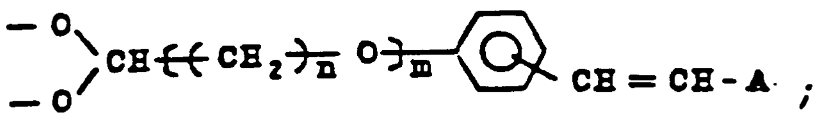 (I)

worin A ausgewählt ist aus den Gruppen, dargestellt durch die allgemeinen Formeln (1) oder (2):

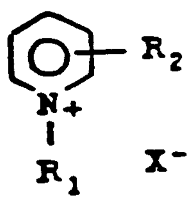 (1)

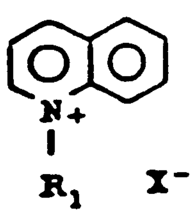 (2)

worin $R_1$ ein Wasserstoffatom, eine Alkyl- oder eine Aralkylgruppe, die eine Hydroxylgruppe, eine Carbamoylgruppe, eine Ethergruppe oder eine ungesättigte Gruppe enthalten kann, darstellt; $R_2$ ein Wasserstoffatom oder eine niedrige Alkylgruppe darstellt; und $X^-$ ein Anion ist,

m eine ganze Zahl von 0 oder 1 und n eine ganze Zahl von 1 bis 6 ist;

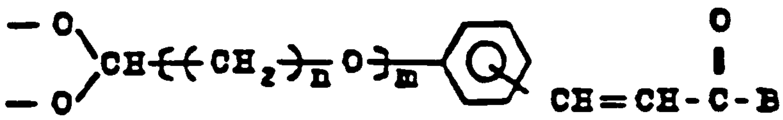

(II)

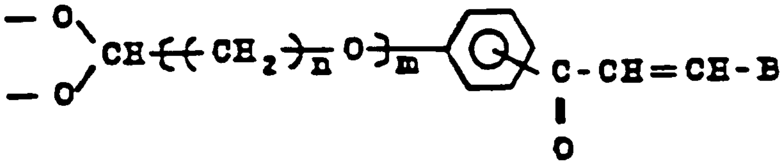

(III)

worin B eine aromatische oder heterocyclische Gruppe mit mindestens einer polaren Gruppe darstellt und m und n wie in der allgemeinen Formel (I) definiert sind;

wobei der lichtvernetzbare Polyvinylalkohol aus Polyvinylalkohol mit einem Verseifungsgrad von 75 Mol% oder mehr hergestellt ist, **dadurch gekennzeichnet**, daß der Polyvinylalkohol 0,5 bis 10 Mol% lichtvernetzbare Struktureinheiten enthält, der Polyvinylalkohol, der verwendet wird, um den lichtvernetzbaren Polyvinylalkohol herzustellen, einen Polymerisationsgrad von 300 bis 3000 hat, das Verhältnis der Film-bildenden Polymerverbindung zu dem lichtvernetzbaren Polyvinylalkohol in der lichtempfindlichen Harzzusammensetzung für ein Siebdruckverfahren 100 Gewichtsteile : 10 bis 200 Gewichtsteile beträgt und die Zusammensetzung weiterhin eine Diazoverbindung umfaßt.

2. Lichtempfindliche Harzzusammensetzung nach Anspruch 1, **dadurch gekennzeichnet**, daß B der allgemeinen Formeln (II) und (III) eine aromatische oder heterocyclische Gruppe ist, die mit einer Carbonsäure oder einem Salz davon, einer Sulfonsäure oder einem Salz davon oder einem primären, sekundärer, tertiären Amin oder einem Salz davon, einschließlich einem quartären Salz eines tertiären Amins, substituiert ist.

3. Lichtempfindliche Harzzusammensetzung nach einem der Ansprüche 1 oder 2, **dadurch gekennzeichnet**, daß die Diazoverbindung ausgewählt ist aus Tetrazoliumsalzen, Diazidverbindungen, Diazoniumsalzen, Diazoharzen, die Kondensate von einem Diazoniumsalz und Formalin sind, und Gemischen davon.

4. Lichtempfindliche Harzzusammensetzung nach Anspruch 3, **dadurch gekennzeichnet**, daß die Diazoverbindung ein Kondensat von 4-Diazo-Diphenylamin und para-Formaldehyd ist.

**Revendications**

1. Composition résineuse photosensible pour sérigraphie, comprenant un composé polymère formant un film et un alcool polyvinylique réticulable sous l'effet d'un rayonnement lumineux et contenant des groupes, réticulables sous l'effet d'un rayonnement lumineux, d'au moins l'un des éléments de l'ensemble constitué des groupes représentés par les formules générales (I), (II) ou (III):

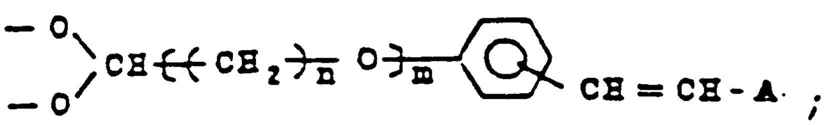

**(I)**

où A est choisi parmi les groupements représentés par les formules générales (1) ou (2):

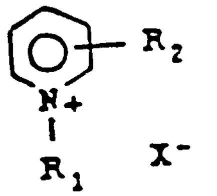

(1)

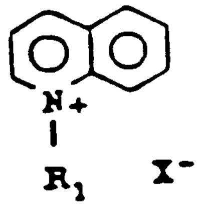

(2)

où $R_1$ est un atome d'hydrogène, ou un radical alcoyle ou un radical aralcoyle qui peut contenir un radical hydroxyle, un radical carbamoyle, un radical éther ou un radical insaturé; $R_2$ est un atome d'hydrogène ou un radical alcoyle d'ordre inférieur; et $X^-$ est un anion,
m est un entier valant 0 ou 1, et n est un entier de 1 à 6;

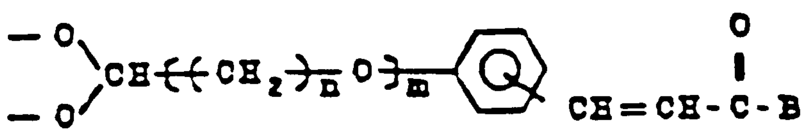

(II)

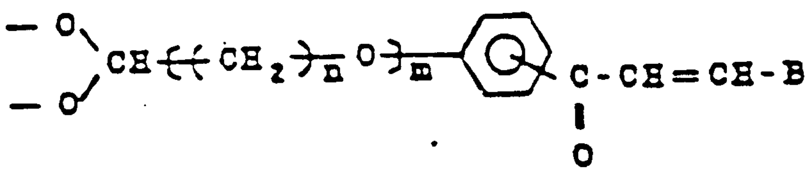

(III)

où B est un radical aromatique ou hétérocyclique présentant au moins une sorte de radical polaire; et m et n sont comme définis dans la formule générale (I);
composition dans laquelle ledit alcool polyvinylique, réticulable sous l'effet d'un rayonnement lumineux, se prépare à partir d'un alcool polyvinylique présentant un degré de saponification de 75 moles %, ou plus, composition caractérisée par le fait que ledit alcool polyvinylique contient de 0,5 à 10 moles pour cent de groupes réticulables sous l'effet d'un rayonnement lumineux, par le fait que l'alcool polyvinylique utilisé pour préparer l'alcool polyvinylique réticulable par l'effet d'un rayonnement lumineux présente un degré de polymérisation de 300 à 3000, et par le fait que le rapport entre le composé polymère formant le film et l'alcool polyvinylique réticulable sous l'effet d'un rayonnement lumineux dans la composition résineuse photosensible pour sérigraphie est de 100 parties en poids pour 10 à 200 parties en poids, et que la composition comporte en outre un composé diazo.

**2.** Composition résineuse photosensible de la revendication 1, caractérisée par le fait que B des formules générales (II) et (III) est un radical aromatique ou hétérocyclique substitué par un acide carboxylique ou son sel, un acide sulfonique ou son sel, ou une amine primaire, secondaire, tertiaire ou son sel, y compris un sel quaternaire d'une amine tertiaire.

**3.** Composition résineuse photosensible de l'une quelconque des revendications 1 ou 2, caractérisée par le fait que l'on choisit le composé diazo parmi les sels de tétrazolium, les composés diazides, les sels de diazonium, les résines diazo qui sont des condensats d'un sel de diazonium avec la formaline, et leurs mélanges.

**4.** Composition résineuse photosensible de la revendication 3, caractérisée par le fait que le composé diazo est un condensat de la 4-diazo-diphénylamine avec le paraformaldéhyde.